# EUROPEAN PATENT SPECIFICATION

(11) **EP 2 540 795 B1**
(45) Date of publication and mention of the grant of the patent: **17.12.2014**
(21) Application number: 11171648.6
(22) Date of filing: 28.06.2011
(51) Int. Cl.: C09K 11/02, C09K 11/80, H01L 33/50

(54) **Fluorescent polyurethane composite and applications thereof**
Fluoreszierender Polyurethanverbundstoff und Anwendungen dafür
Composite de polyuréthane fluorescent et applications associées

(43) Date of publication of application: 02.01.2013
(73) Proprietor: Recticel, 1140 Brussels (BE)
(72) Inventor: De Geeter, Joke, 9230 Wetteren (BE); Vermeersch, Joan, 9230 Wetteren (BE)
(74) Representative: BiiP cvba

(56) References cited:
- US-A1- 2009 102 353
- RYSZKOWSKA ET AL: "Quantitative description of the microstructure of polyurethane nanocomposites with YAG including Tb<3+>", MATERIALS SCIENCE AND ENGINEERING B, ELSEVIER SEQUOIA, LAUSANNE, CH, vol. 146, no. 1-3, 21 December 2007 (2007-12-21), pages 54-58, XP022398803, ISSN: 0921-5107, DOI: 10.1016/J.MSEB.2007.07.044

## Description

### Technical Field

The present invention relates to the field of fluorescent transparent layers. In particular, it concerns polyurethane resins filled with fluorescent particles, such as phosphors, particularly suitable in optical applications, such as in white light emitting LED devices and as pigments in printing media.

### Background for the invention

Many functional materials are in powder form and must be dispersed in a medium to provide their functionalities to various products. In particular, fluorescent particles are particles that emit light after absorption of light (or other electromagnetic radiation) of a different wavelength. In most cases, the emitted light has a longer wavelength, and therefore lower energy, than the absorbed radiation. There are several applications for fluorescent particles. In particular, most white light emitting diode devices make use of a monochrome blue light emitting diode, irradiating a fluorescent layer which absorbs part of the blue light, transmitting the rest of it, mixed with a yellow/green light emitted by fluorescent particles and resulting in a white light.

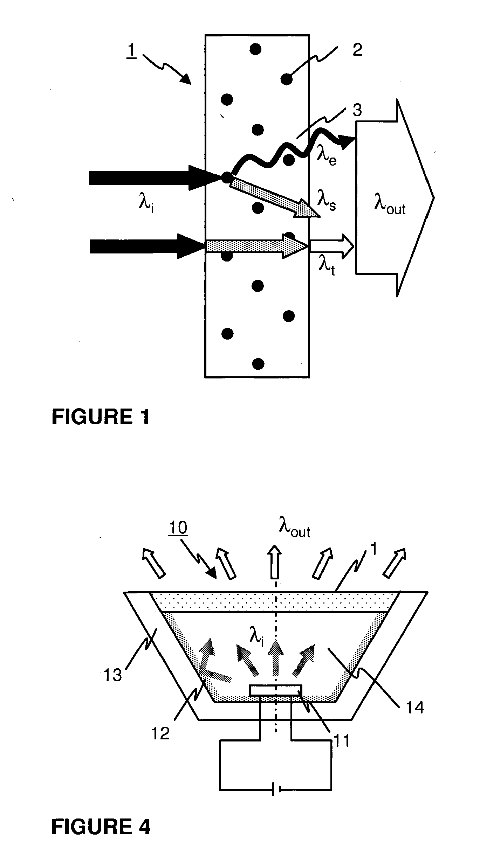

Light emitting diodes (LED) are semiconductors emitting light by recombination of electrons with electron holes. Initially used as indicator lamps in many devices, LED's attract increasing interest in all fields of lighting because they generally have a low power consumption and a long service life. A red light is emitted, e.g., by a GaAsP LED, a green light by, e.g., a GaP LED, and a blue light by, e.g., a InGaN/AlGaN LED. No known semiconductor emits a white light. One technique for providing a white light emitting LED device, comprises a semiconductor mounted on a support and emitting a primary light, e.g., a blue light. The emitted primary light is made to interact with a fluorescent material which, after absorption of a portion of the primary light, λᵢ, emits a secondary light, λₑ, e.g., a yellow-green light (cf. Figure 1). The mixing of the two lights -the primary, λᵢ, and secondary, λₑ, lights- yields a white light, which correlated colour temperature (CCT) depends on a number of parameters. Within the context of the present invention, a white light is defined as a light having a Colour Rendering Index (CRI) of at least 65, preferably at least 70, more preferably at least 75, and most preferably at least 80.

The correlated colour temperature (CCT measured in kelvin [K]), herein referred to simply as "colour temperature", can be defined as the average of the primary component temperatures (RGB CCTs), using trilinear coordinates (cf. Davis, Raymond, National Bureau of Standards Journal of Research, 7: 659-681(1931*).* A white light of temperature over 5000 K is considered a cool colour (= blueish white), whilst a white light having a temperature of 2700-3000 K is called a warm colour (yellowish light to red).

The temperature of the white light emitted by a white light LED device as defined supra depends on the type, size, and concentration of the fluorescent particles used, the matrix in which they are embedded and of course the wavelength emitted by the LED. Various white light emitting LED devices using fluorescent particles were proposed in the art.

In one embodiment, fluorescent particles (e.g., phosphors) may be coated directly onto the semiconductor, such as described in WO200813780 or US2005/01 36782. This option has the inconvenience of heating the phosphors during use, which reduces their service life and efficacy. Alternatively, the fluorescent particles may be coated on, or embedded in a transparent substrate separate from the semiconductor, as disclosed in US20080173889, JP2002133925, US20050006659, and the like. A coating of fluorescent particles -often phosphors are used- allows the reduction of the thickness of the transparent substrate and thus decreases light absorption, but it is scratch sensitive and can be damaged easily. Embedding the phosphors in a resin has the clear advantage of increasing the scratch resistance of the device. On the other hand, the concentration of phosphors per unit volume of transparent substrate required with such devices to obtain the desired white light temperature may increase. This increases the cost of production of the LED device and reduces the lighting efficacy as the fraction of primary light absorbed by the transparent substrate increases with the thickness thereof. Furthermore, it is generally problematic to obtain a uniform dispersion of the phosphor particles within the transparent substrate and to avoid formation of bubbles, both factors being detrimental to the performance of the LED device.

Most white light emitting LED devices produced to date comprise a blue light emitting semiconductor, with a yellow emitting phosphor, Yttrium Aluminum Garnet (YAG), in particular YAG activated by cerium (YAG:Ce). The phosphors are dispersed in a transparent resin such as epoxy (cf. US2002/0185966), silicon (cf. WO06/121196), polycarbonate (cf. US2005/0006659), polyester (cf. US6207077), polyurethane (cf. US2009/0153023), and the like.

Ryszkowska et al. (Materials Science and Engineering, B146 (2008), 54-58) studies the efficiency of monochromaticity of polyurethane nanocomposites filled with YAG:Tb present in amounts of up to 0.2 wt.%. With such contents of YAG:Tb luminescent particles, no white light is emitted.

US2009/0102353 discloses a white light emitting device comprising a matrix made of a polyurethane/vinyl copolymer loaded with luminescent silicon nanoparticles. No information on the amounts of luminescent nanoparticles are disclosed therein.

It is clear that the choice of the resin used to disperse the phosphors will greatly affect the efficacy and cost of the device. The viscosity of the curable resin composition, the curing temperature and time, the transparency to blue and yellow lights of the cured resin are all factors that are critical to the final product cost and performance. Furthermore, the exotherm during curing of these resins can raise the temperature of the mixture to temperatures higher than 100°C, which is detrimental to most fluorescent particles, which are generally quite temperature sensitive.

The present invention proposes a transparent resin loaded with fluorescent particles which solves most of the problems identified supra. Said transparent resin is particularly advantageous for use in white light emitting LED devices.

### Summary of the Invention

The present invention is defined in the appended independent claims. Preferred embodiments are defined in the dependent claims. In particular, the present invention concerns a composite comprising a transparent polyurethane matrix and fluorescent particles dispersed within said matrix, characterized in that, when exposed to a blue light emitting diode said composite emits a radiation which, when mixed with the blue light transmitted through said composite, forms a white light of CCT colour which, in the CCT colour range comprised between 2000 and 10,000 K, is less than A / [fluo]^{B} K, wherein [fluo] is the concentration in fluorescent particles expressed In mg/mm² of composite, and A and B are parameters, wherein A = 1100, and B = 0.8, preferably, A = 1000, more preferably, A = 900, more preferably, A = 800, most preferably, A = 700. Obtaining light of such colour temperature with so low contents of fluorescent particles is from a financial point of view very advantageous.

The fluorescent particles are present in an amount comprised between 0.3 and 30.0 wt.%, preferably between 0.5 and 10.0 wt.%, more preferably between 1.0 and 5.0 wt.% with respect to the total weight of the composite. The fluorescent particles preferably comprise at least one or more of phosphors, quantum dots, luminescent particles. It is more preferred that the fluorescent particles comprise a phosphor, and most preferably an yttrium-aluminium garnet (YAG), such as Y₃Al₅O₁₂:Ce3⁺ (YAG:Ce). The mean diameter of the fluorescent particles is preferably greater than 1 µm.

The fluorescent composite of the present invention preferably further comprises scattering particulate pigments such as TiO₂ (white), Al₂O₃ (white) or ZnO (white). The presence of such pigments enhances the homogeneity in all directions of the white light emitted as defined above.

The transparent polyurethane may be a thermoplastic polyurethane or a thermoset polyurethane. It preferably has a transmittance at a radiation between 430-490 nm (blue region) and 500-700 nm (yellow region) of more than 90 %, preferably more than 95%, more preferably more than 97%.

The present invention also concerns a white light emitting device comprising:
(a) A blue light emitting diode (LED), and
(b) A fluorescent layer,

Characterized in that, the fluorescent layer comprises a composite as defined supra. The blue LED is generally fixed to a substrate and connected to a source of power. The fluorescent layer is interposed between the LED and the area where the light is to be directed. It is possible to position_the blue LED at the bottom of an inner reflecting surface of a concave cup comprising an opening. The fluorescent layer is thus positioned between the blue LED and the cup opening, screening the cup opening completely from the blue LED. The fluorescent layer can be in contact with the LED, even embedding the LED or it can be separate from the LED with an intermediate layer, either of a gas, vacuum, or a resin. The resin can be the same or different from the matrix of the fluorescent layer, but it does not comprise fluorescent particles, as it would then become a fluorescent layer in contact with the LED. It is preferred to separate the fluorescent layer from the LED, inter alia for reducing the exposure of the fluorescent particles to the heat emitted by the LED, as the fluorescent particles are very temperature sensitive.

The present invention also concerns a substrate comprising a printed pattern applied on at least one surface thereof, characterized in that the printed pattern is made of a composite as discussed supra. The pattern is preferably applied with an inkjet printer and the polyurethane matrix is cured by exposure to a radiation, preferably an ultraviolet radiation. Heat curing is also possible, but ultraviolet radiation curing is preferred.

The present invention also concerns a process for the production of a fluorescent composite as discussed supra, said process comprising the following steps:
(a) providing a polyurethane reactive mixture;
(b) blending therewith fluorescent particles to obtain a homogeneous dispersion;
(c) applying the homogenous dispersion onto a substrate
(d) allowing said reactive mixture to polymerize, preferably by heating at a temperature comprised between 25 and 100°C or by exposure to a radiation, more preferably an ultraviolet radiation.

The polyurethane reactive mixture preferably comprises at least a hydroxyl-terminated prepolymer and/or an isocyanate-terminated prepolymer. In particular, it is preferred that the prepolymer has a Brookfield viscosity comprised between 100 and 30,000 mPa.s, preferably between 300 and 10,000 mPa.s, more preferably between 500 and 5000 mPa.s (measured at 25°C with spindle 27 at a rotation rate of 10 rpm).

The present invention also concerns a process for the production of a fluorescent composite comprising the following steps:
(a) providing a polyurethane reactive mixture comprising at least a hydroxyl-terminated prepolymer and/or an isocyanate-terminated prepolymer, said prepolymer having a Brookfield viscosity comprised between 100 and 30,000 mPa.s, preferably between 300 and 10,000 mPa.s, more preferably between 500 and 5000 mPa.s, measured at 25°C with spindle 27 at a rotation rate of 10 rpm;
(b) blending therewith fluorescent particles to obtain a homogeneous dispersion;
(c) applying the homogenous dispersion onto a substrate
(d) allowing said reactive mixture to polymerize, preferably by heating at a temperature comprised between 25 and 100°C or by exposure to a radiation, preferably an ultraviolet radiation.

### Brief description of the Figures

For a fuller understanding of the nature of the present invention, reference is made to the following detailed description taken in conjunction with the accompanying drawings in which:
Figure 1: shows a schematic representation of a primary radiation interacting with a composite according to the present invention.
Figure 2: shows a plot of the CCT colour temperature vs YAG content for three different resins.
Figure 3: shows a plot of the CIE_x vs CIE_y for various YAG concentrations and different resins.
Figure 4: shows a white light emitting LED device according to the present invention.

### Detailed description of the invention

The present invention concerns a composite comprising a transparent polyurethane matrix and fluorescent particles dispersed within said matrix. As illustrated in Figure 1, when exposed to an incident light radiation of given wavelength range, λᵢ, some of the incident radiation is transmitted, λₜ, through the matrix without interacting with any fluorescent particles, whilst some of the incident radiation interacts with a fluorescent particle, excites it and the latter emits a secondary radiation, λₑ, and some of the energy of the incident light is scattered, λₛ. The transmitted light, λₜ, the emitted light, λₑ, and the scattered light, λₛ, emerge from the opposite side of the fluorescent composite forming a light of a given colour, λₒᵤₜ. In reality, the phenomena are more complex as a radiation emitted, λₑ, or scattered, λₛ, as a result of the interaction of the incident radiation; λᵢ, may interact with other particles, and so on. But the representation of Figure 1 is sufficient to understand the main principle of the formation of white light, λₒᵤₜ.

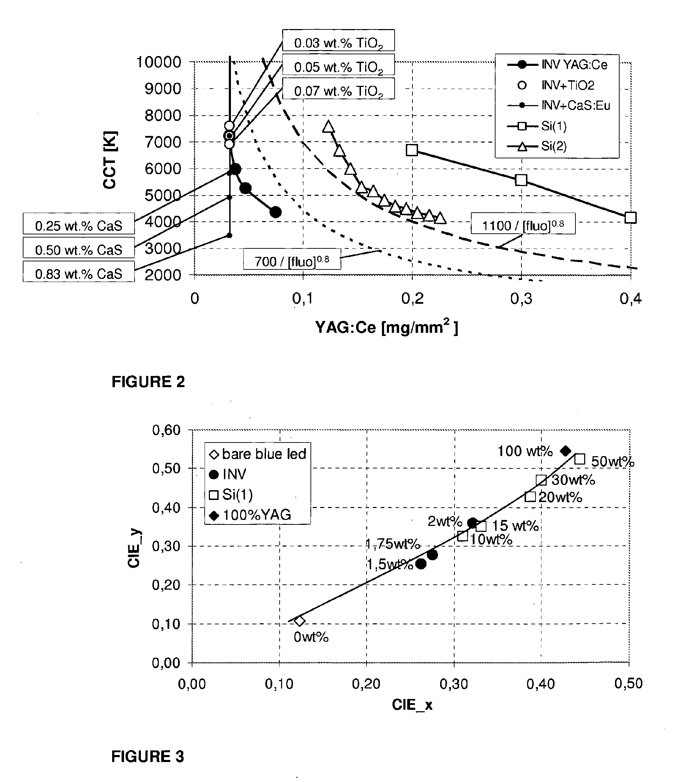

When exposed to a blue light emitting diode, the composite of the present invention emits a radiation which, when mixed with the blue light transmitted through said composite, forms a white light of CCT colour which, in the CCT colour range comprised between 2000 and 10,000 K, is less than A/[fluo]^{B} K, wherein [fluo] is the concentration in fluorescent particles expressed in mg/mm² of composite, and A and B are parameters, wherein A = 1100, and B = 0.8, preferably, A = 700. Figure 2 shows the CCT colour temperature as a function of phosphor volume concentration in a phosphor layer formed by Y₃Al₅O₁₂:Ce3⁺ (= YAG:Ce) in different resins positioned in front of a blue light emitting semiconductor. CCT, CIE and CRI are measured according to the standard defined in CIE DS 014-3.2/E:2010 colorimetry - part 3: CIE tri-stimulus values.

The fluorescent composite according to the present invention (referred to in Figures 2 and 3 as "INV" with black circles) was obtained by using the method described in example 1. The fluorescent layer referred to in Figures 2 and 3 as "Si(1)" with white squares comprises YAG:Ce in a silicon resin as described in H. Quinones, B. Sawatzky, andA. Babiarz, -Silicone-phosphor encapsulation for high power white LEDs": Asymtek, CA USA (2008*). Similarly,* the fluorescent layer referred to in Figure 2 as "Si(2)" with white triangles comprises YAG:Ce in a silicon resin as described in N.T. Tran and F.G. Shi, "Studies of phosphor concentration and thickness for phosphor-based white light-emitting-diodes, "Journal of Lightwave technology, vol 26, n°21, p.3556-3559 (2008*)*. The CCT colour temperature of the resulting white lights emitted by the three devices is plotted as a function of YAG:Ce content expressed in terms of mg / mm² to compare the results from various sources independently of the thickness of the composite layers.

It can be seen in Figure 2 that for a resulting radiation of a given CCT colour temperature, a polyurethane composite layer according to the present invention requires about half of the YAG:Ce content of Si(2) and only about a quarter of the YAG:Ce content of Si(1). This substantial reduction in YAG:Ce content required to achieve the same colour temperature compared with the prior art, is attributed to the excellent distribution of the fluorescent particles in the transparent polyurethane resin. The curve with a dashed line is the upper boundary for the CCT colour as a function of the content of fluorescent particles, [fluo], defined in claim 1 as CCT ≤ 1100 [fluo]^{0.8} K, with [fluo] being the YAG:Ce content of the composites measured in mg / mm² of surface of the composite exposed to the incident radiation. The curve in dotted line is the preferred upper boundary defined in claim 1 as CCT ≤ 700 [fluo]^{0.8} K. It can be seen in Figure 2 that the curves corresponding to the two silicone based composites are far offset to the right of the boundary curves defined in claim 1.

The content of fluorescent particles in a composite according to the present invention is comprised between 0.3 and 30.0 wt.%. preferably between 0.5 and 10.0 wt.%, more preferably between 1.0 and 5.0 wt.%, with respect to the total weight of the composite. The optimal fluorescent particles content depends much on the density of the particles, whether organic or inorganic, and of course on the desired colour temperature of the resulting light. For example, a warm white colour of temperature of the order of 2500-3000 K can be obtained with not more than 0.15 mg / mm² of fluorescent particles. On the other hand, a colder white light of temperature 5000-10,000 K can be obtained with less than about 0.05 mg/mm².

Small amounts of other pigments can be added to the composition of a fluorescent composite according to the present invention. Their presence is not meant to affect substantially the colour temperature emitted by a white light emitting LED device, but rather to homogenise the emitted light, which is a recombination of various radiations: transmitted primary radiation, λₜ; radiation, λₛ, scattered by the fluorescent particles; radiation, λₑ, emitted by the fluorescent particles, etc. The presence of a small amount of pigments seems, without wishing to be bond by any theory, to scatter the various radiations in various directions, thus resulting in a more homogeneous white light perceived by the users in all directions. Preferred pigments are white pigments like TiO₂, ZnO or Al₂O₃, but other colours can be used instead, even red or black pigments, like carbon black, provided their size and content does not reduce too much the transmittance of the composite. Very small amounts of pigments are required to obtain a result. The scattering pigments should not be present in an amount greater than 0.5 wt.%, lest they would affect the transmittance of the composite. Typically, not more than 0.2 wt.% pigments is required, preferably, not more than 0.1 wt.%, more preferably not more than 0.08 wt.%. The effect on the CCT colour temperature of the amount of TiO₂ present in the composite is illustrated in Figure 2 for a composite comprising 0.03, 0.05 and 0.06 wt.% white pigment TiO₂. It can be seen that the presence of white pigment does affect the CCT colour temperature of the composite, but in the amounts envisaged in the present invention, this is not the objective. It can be seen from Table 2 that the presence of higher amounts of pigments is detrimental to the luminous efficiency of the light device. The right amount of pigment shall therefore be a compromise between the best homogenisation of the light to an acceptable drop in the luminous efficiency of the light device.

Figure 3 plots the x and y CIE components of the light colour emitted from the same samples according to the invention and for Si(1) as plotted in Figure 2. The data is flanked on either extremities by the resulting light temperature obtained with a bare blue light (white diamond in Figure 3) and pure YAG:Ce (black diamond in Figure 3). It can be seen that all the data align along a soft curve, not quite linear. The composites according to the present invention (black circles) comprise from 1.5 to 2.0 wt.% fluorescent particles, whilst the amounts required for the Si(1) composites to align on said curve are substantially higher. It is particularly interesting that the colour obtained by a PU composite according to the present invention comprising 2 wt.% YAG:Ce is comprised between two Si(1) composites comprising 10 and 15 wt.% YAG:Ce, respectively, i.e., 5 to 7.5 times more. Considering the cost of YAG:Ce, this reduction in YAG:Ce content is very advantageous financially speaking.

The preferred fluorescent particles for the present invention are phosphors of the type yttrium-aluminium garnets (YAG) and, in particular, cerium doped YAG, Y₃Al₅O₁₂:Ce3⁺, (YAG:Ce) as used in the composites represented in Figures 2&3. Other fluorescent particles, however, can be used successfully within the ambit of the present invention. In particular, other phosphors, quantum dots, luminescent particles, and the like.

The fluorescent particle size can be measured by different methods. For instance, the particle mean diameter can be measured with a Coulter Counter (50µm aperture). In the present invention it is preferred that the fluorescent particles have a mean diameter greater than 500 nm, preferably greater than 1 µm. It is preferred that the fluorescent particles have a mean diameter smaller than 25 µm, preferably smaller than 20 µm, more preferably smaller than 10 µm.

The transparent polyurethane matrix preferably has a transmittance at a radiation between 430-490 nm (blue region) and 500-700 nm (yellow region) of more than 90 %, preferably more than 95%, more preferably more than 97%. A high transparency is preferred so that a maximum output of e.g. a light device can be obtained. Transparency of a polymer can be measured using a Hunterlab UltraScan PRO apparatus, whereby transmission (T) and reflection (R) are measured in the d/8 geometry (diffuse - 8°) according to the standard ASTM E179-96. Absorption (A) is then calculated as the complementary to the sum of reflection and transmission as: A = 1 - (R+T). Transmission and reflection were measured on 1.6 mm thick samples.

A fluorescent composite according to the present invention can be produced by a process comprising the following steps:
(a) providing a polyurethane reactive mixture;
(b) blending therewith fluorescent particles to obtain a homogeneous dispersion;
(c) applying the homogenous dispersion onto a substrate
(d) allowing said reactive mixture to polymerize, preferably by heating at a temperature comprised between 25 and 100 °C or by exposure to a radiation, preferably an ultraviolet radiation.

In a preferred embodiment, the fluorescent particles are present in the mixture in an amount of less than 10 wt.%, preferably comprised between 0.3 and 5.0 wt.% with respect to the total weight of the mixture.

The polyurethane reactive mixture of the present application can yield a thermoplastic polyurethane (TPU) or a thermoset polyurethane resin. As used herein, the term "thermoplastic" is used in its broad sense to designate a polymer that turns to a liquid when heated above its melting temperature and freezes to a very glassy state and possibly crystallizes when cooled sufficiently. Most thermoplastics are high-molecular-weight polymers whose chains associate through weaker bonds than covalent bonds (e.g., Van der Waals forces, dipole-dipole interactions, and hydrogen bonding). Thermoplastic polymers differ from thermosetting polymers in that they can be remelted and remoulded. A "thermoset" resin, on the other hand designates a polymer material that irreversibly cures forming a three dimensional network of covalent bonds. Contrary to thermoplastic polymers, a thermoset resin cannot be re-processed after curing. It should be clear that the polyurethane resin not only includes polyurethane linkages, but may include urea, allophanate, carbodiimide, uretidinedione, and other linkages in addition to urethane linkages. Polyurethane polymers can be prepared through the reaction of an organic polyisocyanate with a polyol using standard well-known procedures. Conventionally, a polyurethane may be produced according to a so-called 'one shot' process whereby a polyol is mixed with a diisocyanate and/or a polyisocyanate in the presence of other components such as catalysts, so that the polyurethane is formed in one step. In a preferred embodiment of the invention, the polyurethane reactive mixture of the invention comprises at least a hydroxyl-terminated prepolymer and/or an isocyanate-terminated prepolymer. A hydroxyl-terminated prepolymer is prepared by reacting a polyol with a stoichiometric deficiency of the polyisocyanate to form a prepolymer with residual hydroxyl groups. In a next step this prepolymer is reacted with the residual amount of isocyanate to form the polyurethane material. Alternatively use can be made of NCO-terminated prepolymers, wherein the di- or polyisocyanate is in a first step reacted with a deficiency of the polyol, and is in a next step reacted with the residual amount of polyol.

The use of this prepolymer technique for producing polyurethane materials has various advantages. First, the exotherm produced during polyurethane polymerization is substantially reduced compared with the one-shot technique. Since most fluorescent particles are temperature sensitive, the use of prepolymers advantageously prevents the fluorescent particles from exposure to excessive temperature.

Another advantage of the prepolymer technique over the one-shot process is that the viscosity of the prepolymers can be controlled, which allows to optimize the formation of a stable and homogeneous suspension of phosphor particles in the curable composition. Indeed, if the viscosity is too low, the particles will tend to rapidly settle and if the viscosity is too high, it will be difficult to obtain a homogeneous suspension. In many applications, such as in white light emitting LED devices, it is important to have a homogeneous dispersion of fluorescent particles in the fluorescent layer for various reasons. First, a homogeneous fluorescent particles dispersion in the fluorescent layer yields a homogeneous light in terms of colour, intensity, etc., in all directions of the emitted white light. Second, since the colour of the emitted white light is the result of the mixing of the blue primary light emitted by the semiconductor, and the yellow secondary light emitted by the phosphors upon absorption of a fraction of the primary blue light (cf. Figures 1&4), it is clear that less fluorescent particles are required if they are dispersed more homogeneously within the fluorescent layer. Since the fluorescent particles are, after the semiconductor, the most expensive element of a LED device, it is quite interesting to reduce the amount thereof needed to obtain the desired light colour temperature. Finally, the transmittance of the fluorescent layer is increased with a homogeneous distribution of the phosphors, increasing the lumen performance of the diode device. In addition, the use of prepolymer technology further allows to better control and tailor the final mechanical properties of the polyurethane composite such as tensile strength.

The Brookfield viscosity of the prepolymer according to the invention should be comprised between 100 and 30,000 mPa.s, preferably between 300 and 10,000 mPa.s, more preferably between 500 and 5000 mPa.s, measured at 25°C with spindle 27 at a rotation rate of 10 rpm.

The fluorescent particles may be mixed together with the whole polyurethane reactive mixture at once, or it may be premixed with one or several components of said reactive mixture prior to being mixed with the remaining components. The latter option is particularly interesting when a prepolymer is used, as a stable intermediate dispersion of the fluorescent particles therein can thus be obtained, which is then blended with the remaining components of the reactive mixture. Blending and mixing can take place in a mixer as well known in the art or in an extruder or injection moulding screw. Double screw extruders can be advantageously used to ensure a more homogeneous mixture. A mixture is considered to be homogeneous if a polymerized composite plate of 1 cm² area and 2 mm thickness comprises no gradient in particles concentration above 10%, preferably above 5% throughout the whole area thereof. Analysis of the particle concentration can be made by image analysis on micrographs of the plate surface or by rheological measurements as well known by the persons skilled in the art. Great care must be taken to prevent formation of gas bubbles which are detrimental to the homogeneity of the final part. This is particularly important in any optical application, such as in white light emitting LED devices, since gas bubbles scatter the light thus reducing the transparency of the matrix and the intensity of the emitted light. Bubble formation can be reduced or eliminated by a proper degassing of the reactive mixture and by controlling the shear rate during mixing.

The homogeneous dispersion can be applied onto any type of substrate. The substrate can be a mould, for example an injection moulding mould or a reactive injection moulding (RIM) mould, into which the homogenous dispersion can be poured in or injected into to shape a fluorescent composite of desired shape. Alternatively, the substrate may be any surface to be coated or printed, such as paper, foils made of polymer or metal, glass, ceramic, textile, and the like. The surface on which it is applied can be textured or not. The reactive blend can be applied on such substrates by printing with an ink-jet printer, by spraying, pouring, brushing, extruding, rotational disc coating, roto-coating, and the like.

Polymerization of the reactive polyurethane mixture can be completed by exposure of the reactive blend to a temperature sufficient to achieve polymerization or curing of the blend. In order to prevent degradation of the fluorescent particles, the temperature should not be higher than 100°C. A temperature below 20°C would not allow a satisfactory reaction rate. Alternatively, the composition may be reactive to exposure to a radiation, such as ultraviolet, X-ray, microwave, and the like. Preferably, the radiation is ultraviolet. Ultraviolet initiators are well known in the art such as 2,2-azobisisobutyronitrile (AIBN), 1-hydroxycyclohexylphenylketone, 2,2-dimethoxy-1,2-diphenylethan-1-one, 1-[4-(2-hydroxyethoxy)-phenyl]-2-methyl-1-propanone (HHPMP), bis(2,4,6-trimethylbenzoyl)-phenyl-phosphoneoxide (BTPPO), and the like.

Once polymerized, a fluorescent composite according to the present invention is obtained. The use of a polyurethane matrix in the fluorescent composite offers many advantages. First, it allows a good control of the reactive composition viscosity ensuring an optimal dispersion of the fluorescent particles in the polyurethane matrix, thus reducing the amount of particles required to reach a given CCT colour temperature. Second, polyurethane has a great transparency, which can be greater than 90% or even 97% to blue light. Third, polyurethanes resins can be made light stable by using aliphatic di- or polyisocyanates, contrary to e.g., epoxy resins which undergo substantial yellowing when exposed to light. Similarly polyurethane resins have a high thermal stability. Next to that, the mechanical properties can be tailored as a function of the desired final applications. Polyurethane materials can have a Young's modulus varying from 100 kPa to 1 00 MPa at 25°C. Similarly, shore hardness can be varied from 1 to 90. Finally, the wide variety of available processing and moulding technologies makes polyurethanes very suitable for many diverse applications.

A fluorescent composite according to the present invention is particularly advantageous for use in white light emitting devices. A white light emitting device according to the present invention therefore comprises:
(a) A blue light emitting diode (LED) (11), and
(b) A fluorescent layer (1).

The fluorescent layer of a white light emitting LED according to the present invention comprises a composite as discussed supra. A blue LED (11) is normally fixed on a support and the fluorescent layer (1) is interposed between the blue LED and the target to be lit. Many white light emitting devices comprise a concave cup (13) having a reflective inner surface (12) and comprising an opening. The blue LED (11) is positioned at the bottom of such concave cup and the fluorescent layer (1) is positioned between the blue LED and the cup opening, screening the cup opening completely from the blue LED. This way the primary radiation; λᵢ, must necessarily interact with the fluorescent composite and the target is radiated with white light, λₒᵤₜ, only. The reflecting surface (12) allows to redirect towards the fluorescent composite any reflected or scattered rays.

The fluorescent layer (1) can be applied such as to embed the blue LED (11). This ensures that all primary rays, λᵢ, necessarily interact with the fluorescent layer. Most fluorescent particles are, however, temperature sensitive and it is preferred to separate the fluorescent layer from the blue LED by a space (14), since the blue LED, when activated, produces considerable heat. The space (14) may be filled by a material, such as a resin, preferably the same polyurethane as the one used as matrix in the fluorescent layer to avoid diffraction and reflections phenomena. The space (14) may also be empty, either under vacuum or filled with a gas such as air, N₂, Ar, and the like.

The fluorescent composite of the present invention can also advantageously be used as printing medium. In particular, a reactive mixture comprising fluorescent particles dispersed therein can be applied in a liquid form onto a substrate by means well known in the art, such as an ink-jet printer and the polyurethane be polymerized, for example by application of heat or exposure to a radiation, such as a UV radiation. Other application techniques can be used, such as screen printing, spraying and any printing or coating technique well known to the persons skilled in the art. A fluorescent pattern according to the present invention may be applied on different types of substrates, such as a plastic or metal foil, paper, tape, a transparent material such as a polymer or glass, metals, textile, and the like.

### Examples

To illustrate the present invention, the following samples were produced as follows.

### (a) Preparation of a polyol-,blend 1

A mixture containing some or all of a polyol A, polyol B, anti-oxidant package, scattering particulate pigments and/or other additives is mixed for at least 2 minutes at a speed of 2000 rpm until the mixture has a uniform appearance. The complete mixture (hereafter called "polyol-blend 1") is heated up to a temperature of 50°C and degassed for 30 minutes in a high-vacuum oven at 50°C.

### (b) Preparation of a fluorescent polyol-,blend 2

A mixture is made of polyol-blend 1 and a given amount of cerium doped yttrium aluminum garnet phosphor (YAG:Ce) (QMK58/F U1 from Phosphor Technology) and/or other fluorescent particles such as *red phosphor europium doped calcium sulphide (CaS:Eu) (FL63*/*S-D1 from Phosphor Technology),* and is mixed for at least 2 minutes at a speed of 2000 rpm until the mixture has a uniform appearance. The complete mixture (hereafter called "fluorescent polyol-blend 2") is heated up to a temperature of 50°C and degassed for 30 minutes in a high-vacuum oven at 50°C.

### (c) Preparation of the NCO- terminated prepolymer

An amount of aliphatic isocyanate is heated at 80°C. After heating, a specific amount of polyol is added and mixed with the isocyanate The mixture is heated at 85°C for 2 hours to react the components. As a result, a NCO-terminated prepolymer (hereafter called *"prepolymer"*) with a NCO% around 13,7% and a Brookfield viscosity around 1500 mPa.s (25°C) was made. The *prepolymer* is degassed for 30 minutes in a high-vacuum oven at 50°C.

### (d) Preparation of a transparent polyurethane matrix

An amount of *polyol-blend 1* as listed in Tables 1 &2 is placed in a jar and a given amount of the *prepolymer* is added and mixed for 30 seconds at 500 rpm. Afterwards, this mixture is degassed for 10 minutes in an oven at 50°C. A catalyst is added to the previous mixture and mixed for 10 seconds at 500 rpm. This reactive mixture is poured in a mould at about 80°C to a constant thickness of 1.6 mm. The obtained transparent polyurethane matrix is removed from the mould after 30 minutes and post-cured at room temperature. The properties of various polyurethane matrices are listed in Table 1.

### (e) Preparation of a transparent fluorescent composite

An amount of *fluorescent polyol-blend 2* listed in Tables 1 &2 is placed in a jar and a given amount of the *prepolymer* is added and mixed for 30 seconds at 500 rpm. Thereafter, these mixtures are degassed for 10 minutes in an oven at 50°C. Then, a catalyst is added to the previous mixtures and mixed for 10 seconds at 500 rpm. These reactive mixtures are poured in corresponding moulds at 80°C to a constant thickness. The obtained transparent fluorescent composites are removed from the moulds after 30 minutes and post-cured at room temperature. Properties of the fluorescent composites are listed in Table 2.

The mechanical properties of transparent polyurethane matrices suitable for the present invention listed in Table 1, illustrate the wide variety of properties available with polyurethane matrices, allowing the use of fluorescent composites in many different applications requiring stiffness, for which Example 10 would be suitable or flexibility, in which case Example 11 would be selected.

**Table 1: properties of transparent polyurethane matrices according to the present invention.**

| **Reference number** | **EX.1** | **EX.10** | **EX.11** |
|---|---|---|---|
| Polyol A (wt%) | 10,2 | 11,7 | 7,4 |
| Polyol B (wt%) | 8,1 | | 22,4 |
| AO-package (wt%) | 0,85 | 0,97 | 0,62 |
| Catalyst (wt%) | 0,51 | 0,04 | 0,45 |
| NCO-prepolymer (wt%) | 80,3 | 87,3 | 69,1 |
| Scattering particulate pigments (wt%) | 0,05 | 0,06 | |
| Bending modulus (ASTM D790/I/B) | 11,3 ± 0,2 | 71 ± 5 | 3,5 ± 0,2 |
| Tensile modulus (ASTM D1 708) [MPa] | 26 ± 5 | 160 ± 20 | 2,5 ± 0,3 |
| Tensile strength (ASTM D1 708) [MPa] | 16 ± 2 | 15 ± 2 | 9 ± 1 |
| Tensile elongation (ASTM D1 708) [%] | 500 ± 30 | 300 ± 20 | 750 ± 40 |
| Tear resistance (ISO 34-1B(b)) [N/mm] | 30 ± 2 | 58 ± 4 | 11 ± 1 |
| Shore A 3 sec (DIN 53505) [-] | 79 ± 2 | 90 ± 1 | 48 ± 1 |
| Shore D 3 sec (DIN 53505) [-] | 23 ± 1 | 40 ± 1 | - |
| Transmittance (430-490 nm) [%] | 97.6 | 97.3 | |
| Transmittance (500-700 nm) [%] | 97.5 | 97.5 | |

| | | | |
|---|---|---|---|
| Polyol A = Polyol-blend with functionality 2,15 and MW between 95-100 g/mol Polyol B = Polyol with functionality 2 and MW around 1000 g/mol NCO-prepolymer = NCO-terminated prepolymer with a NCO% around 13,7% | | | |

The results listed in Table 2 show how the CCT colour temperature obtained with fluorescent composites according to the present invention may be varied over a broad range of values from ca 3500 to about 11,500 K with a very low content of fluorescent particles of less than 2 wt.%. Lowering the content of fluorescent particles to reach a given colour temperature is advantageous, on the one hand, in terms of cost, as fluorescent particles are expensive and represent a substantial fraction of the total cost of a fluorescent composites and, on the other hand, in terms of luminous efficiency which decreases rapidly with increasing content of fluorescent particles. A lower luminous efficiency must be compensated by the use of more powerful LED's and the consumption of more energy in use. There is therefore a strong driving force to develop fluorescent composites allowing the desired white light colour temperature to be achieved with lower amounts of fluorescent particles.

The use of different types of fluorescent particles, such as YAG:Ce and CaS:Eu can yield advantageous properties with even less total amount of fluorescent particles as illustrated in Figure 2, small black circles.

**Table 2: properties of transparent fluorescent composites according to the present invention.**

| **Reference number** | **EX.2** | **EX.3** | **EX.4** | **EX.5** | **EX.6** | **EX.7** | **EX.8** | **EX.9** |
|---|---|---|---|---|---|---|---|---|
| Polyol A (wt%) | 10,0 | 11,5 | 11,4 | 10,0 | 10,0 | 10,0 | 10,0 | 10,0 |
| Polyol B (wt%) | 8,0 | | | 8,0 | 8,0 | 7,9 | 7,9 | 7,9 |
| Anti-oxidant-package (wt%) | 0,84 | 0,95 | 0,95 | 0,84 | 0,84 | 0,84 | 0,83 | 0,83 |
| Catalyst (wt%) | 0,50 | 0,04 | 0,04 | 0,50 | 0,50 | 0,50 | 0,50 | 0,50 |
| NCO-prepolymer (wt%) | 78,9 | 85,8 | 85,6 | 78,9 | 78,8 | 78,7 | 78,5 | 78,2 |
| Scattering particulate pigments (wt%) | 0,05 | | | 0,03 | 0,06 | 0,05 | 0,05 | 0,05 |
| YAG:Ce (wt%) | 1,75 | 1,75 | 2,00 | 1,75 | 1,75 | 1,75 | 1,75 | 1,75 |
| CaS:Eu (wt%) | | | | | | 0,25 | 0,50 | 0,83 |
| CCT (K) | 7214 | 11 526 | 5 958 | 7 579 | 6893 | 5 799 | 4918 | 3 471 |
| CIE_x | 0,30 | 0,28 | 0,32 | 0,30 | 0,31 | 0,33 | 0,34 | 0,36 |
| CIE_y | 0,32 | 0,28 | 0,36 | 0,32 | 0,33 | 0,30 | 0,28 | 0,27 |
| CRI | 78 | 82 | 73 | 78 | 77 | 92 | 81 | 71 |
| Luminous efficiency (Im/W) | 196 | 173 | 191 | 194 | 190 | 143 | 115 | 94 |

| | | | | | | | | |
|---|---|---|---|---|---|---|---|---|
| Polyol A = Polyol-blend with functionality 2,15 and MW between 95-100 g/mol Polyol B = Polyol with functionality 2 and MW around 1000 g/mol NCO-prepolymer = NCO-terminated prepolymer with a NCO% around 13,7% | | | | | | | | |

## Claims

1. Composite comprising a transparent polyurethane matrix and fluorescent particles dispersed within said matrix, **characterized in that**, when exposed to a blue light emitting diode said composite emits a radiation which, when mixed with the blue light transmitted through said composite, forms a white light of CCT colour which, in the CCT colour range comprised between 2000 and 10,000 K, is less than A / [fluo]^{B} K, wherein [fluo] is the concentration in fluorescent particles expressed in mg/mm² of composite, and A and B are parameters, wherein A = 1100, and B = 0.8, preferably, A = 700, and wherein the fluorescent particles are present in an amount comprised between 0.3 and 30.0 wt.%.

2. Composite according to claim 1, wherein the fluorescent particles are present in an amount comprised between 0.5 and 10.0 wt.%, more preferably between 1.0 and 5.0 wt.% with respect to the total weight of the composite.

3. Composite according to claim 1 or 2, wherein the fluorescent particles comprise at least one or more of phosphors, quantum dots, luminescent particles, preferably a phosphor, more preferably an yttrium-aluminium garnet (YAG).

4. Composite according to the preceding claim, wherein the phosphor is Y₃Al₅O₁₂:Ce3⁺.

5. Composite according to any of the preceding claims, wherein the fluorescent particles have a mean diameter greater than 500 nm, preferably greater than 1 µm.

6. Composite according to any of the preceding claims, wherein the transparent polyurethane matrix has a transmittance at a radiation in the ranges between 430-490 nm and 500-700nm of more than 90 %, preferably more than 95%, more preferably more than 97%.

7. White light emitting device comprising:
(a) A blue light emitting diode (LED), and
(b) A fluorescent layer,
**Characterized in that**, the fluorescent layer comprises a composite according to any of the preceding claims.

8. White light emitting device according to the preceding claim, wherein the blue LED is positioned at the bottom of a concave cup comprising an inner reflecting surface as well as an opening, and the fluorescent layer is positioned between the blue LED and the cup opening, screening the cup opening completely from the blue LED.

9. White light emitting device according to claim 7 or 8, wherein the fluorescent layer is separate from the blue light emitting diode.

10. Substrate comprising a printed pattern applied on at least one surface thereof, **characterized in that** the printed pattern is made of a composite according to any of claims 1 to 6.

11. Substrate according to the preceding claim, wherein the pattern is applied with an inkjet printer, screen printing, or spraying and the polyurethane matrix is cured by exposure to a radiation, preferably an ultraviolet radiation.

12. Process for the production of a fluorescent composite according to any of claims 1 to 6, said process comprising the following steps:
(a) providing a polyurethane reactive mixture;
(b) blending therewith fluorescent particles to obtain a homogeneous dispersion;
(c) applying the homogenous dispersion onto a substrate
(d) allowing said reactive mixture to polymerize, preferably by heating at a temperature comprised between 25 and 100°C or by exposure to a radiation, preferably an ultraviolet radiation.

13. A process according to the preceding claim, wherein the polyurethane reactive mixture comprises at least a hydroxyl-terminated prepolymer and/or an isocyanate-terminated prepolymer

14. A process according to the preceding claim, wherein the prepolymer has a Brookfield viscosity comprised between 100 and 30,000 mPa.s, preferably between 300 and 10,000 mPa.s, more preferably between 500 and 5000 mPa.s measured at 25°C with spindle 27 at a rotation rate of 10 rpm.

## Patentansprüche

1. Verbundstoff, umfassend eine transparente Polyurethanmatrix und fluoreszierende Partikel, die in der Matrix dispergiert sind, **dadurch gekennzeichnet, dass**, wenn der Verbundstoff einer blauen Licht emittierenden Diode ausgesetzt ist, eine Strahlung emittiert, die, wenn sie mit dem blauen Licht, das durch den Verbundstoff übertragen wird, gemischt wird, ein weißes Licht aus CCT-Farbe bildet, das im CCT-Farbbereich zwischen 2.000 und 10.000 K weniger als A / [fluo]^{B} K beträgt, wobei [fluo] die Konzentration in fluoreszierenden Partikeln ist, ausgedrückt in mg/mm² Verbundstoff, und A und B Parameter sind, wobei A = 1.100 und B = 0,8, vorzugsweise A = 700, und wobei die fluoreszierenden Partikel in einer Menge vorhanden sind, die zwischen 0,3 und 30,0 Gew.% liegt.

2. Verbundstoff nach Anspruch 1, wobei die fluoreszierenden Partikel in einer Menge vorhanden sind, die zwischen 0,5 und 10,0 Gew.%, insbesondere zwischen 1,0 und 5,0 Gew.% mit Bezug auf das Gesamtgewicht des Verbundstoffs liegt.

3. Verbundstoff nach Anspruch 1 oder 2, wobei die fluoreszierenden Partikel mindestens eines oder mehrere von Phosphoren, Quantenpunkten, lumineszenten Partikeln, vorzugsweise einem Phosphor, insbesondere einem Yttrium-Aluminium-Granat (YAG) umfassen.

4. Verbundstoff nach dem vorhergehenden Anspruch, wobei der Phosphor Y₃Al₅O₁₂:Ce3⁺ ist.

5. Verbundstoff nach einem der vorhergehenden Ansprüche, wobei die fluoreszierenden Partikel einen mittleren Durchmesser von mehr als 500 nm, vorzugsweise von mehr als 1 µm aufweisen.

6. Verbundstoff nach einem der vorhergehenden Ansprüche, wobei die transparente Polyurethanmatrix eine Durchlässigkeit bei einer Strahlung in den Bereichen zwischen 430 - 490 nm und 500 - 700 nm von mehr als 90%, vorzugsweise mehr als 95%, insbesondere mehr als 97% aufweist.

7. Weiße Licht emittierende Vorrichtung, umfassend:
(a) eine blaue Licht emittierende Diode (LED), und
(b) eine fluoreszierende Schicht,
**dadurch gekennzeichnet, dass** die fluoreszierende Schicht einen Verbundstoff nach einem der vorhergehenden Ansprüche umfasst.

8. Weiße Licht emittierende Vorrichtung nach dem vorhergehenden Anspruch, wobei die blaue LED auf der unteren Seite eines konkaven Bechers positioniert ist, umfassend eine innere reflektierende Fläche, ebenso wie eine Öffnung, und die fluoreszierende Schicht zwischen der blauen LED und der Becheröffnung positioniert ist und die Becheröffnung vollständig von der blauen LED abschirmt.

9. Weiße Licht emittierende Vorrichtung nach Anspruch 7 oder 8, wobei die fluoreszierende Schicht von der blauen Licht emittierenden Diode getrennt ist.

10. Substrat, umfassend ein gedrucktes Muster, das auf mindestens einer Fläche davon aufgebracht ist, **dadurch gekennzeichnet, dass** das gedruckte Muster aus einem Verbundstoff nach einem der Ansprüche 1 bis 6 hergestellt ist.

11. Substrat nach dem vorhergehenden Anspruch, wobei das Muster mit einem Tintenstrahldrucker, durch Siebdruck oder Sprühen aufgebracht wird, und die Polyurethanmatrix durch Aussetzung an eine Strahlung, vorzugsweise eine Ultraviolettstrahlung, ausgehärtet wird.

12. Verfahren zur Herstellung eines fluoreszierenden Verbundmaterials nach einem der Ansprüche 1 bis 6, wobei das Verfahren die folgenden Schritte umfasst:
(a) Zurverfügungstellen einer Polyurethanreaktionsmischung;
(b) Mischen von fluoreszierenden Partikeln damit, um eine homogene Dispersion zu erhalten;
(c) Anwenden der homogenen Dispersion auf ein Substrat;
(d) Ermöglichen der Polymerisierung der Reaktionsmischung, vorzugsweise durch Erhitzen bei einer Temperatur, die zwischen 25 und 100°C liegt, oder durch Aussetzung an eine Strahlung, vorzugsweise eine Ultraviolettstrahlung.

13. Verfahren nach dem vorhergehenden Anspruch, wobei die Polyurethanreaktionsmischung mindestens ein Hydroxyl-terminiertes Präpolymer und/oder ein Isocyanat-terminiertes Präpolymer umfasst.

14. Verfahren nach dem vorhergehenden Anspruch, wobei das Präpolymer eine Brookfield-Viskosität aufweist, die zwischen 100 und 30.000 mPa.s liegt, vorzugsweise zwischen 300 und 10.000 mPa.s, insbesondere zwischen 500 und 5.000 mPa.s, gemessen bei 25°C mit Spindel 27 bei einer Rotationsrate von 10 rpm.

## Revendications

1. Composite comprenant une matrice de polyuréthane transparente et des particules fluorescentes dispersées au sein de ladite matrice, **caractérisé en ce que**, quand il est exposé à une diode émettant une lumière bleue, ledit composite émet un rayonnement qui, quand il est mélangé avec la lumière bleue transmise à travers ledit composite, forme une lumière blanche de couleur CCT qui, dans la gamme de couleurs CCT comprise entre 2000 K et 10 000 K, est inférieure à A/[fluo]⁸ K, dans lequel [fluo] est la concentration en particules fluorescentes exprimée en mg/mm² de composite, et A et B sont des paramètres, dans lesquels A = 1 100 et B = 0,8, de préférence A = 700, et dans lequel les particules fluorescentes sont présentes en une quantité comprise entre 0,3% et 30,0% en poids.

2. Composite selon la revendication 1, dans lequel les particules fluorescentes sont présentes en une quantité comprise entre 0,5% et 10,0% en poids, de manière davantage préférée entre 1,0% et 5,0% en poids par rapport au poids total du composite.

3. Composite selon la revendication 1 ou 2, dans lequel les particules fluorescentes comprennent un/une ou plusieurs luminophores et/ou points quantiques et/ou particules luminescentes, de préférence un luminophore, de manière davantage préférée à grenat d' yttrium et d'aluminium (YAG).

4. Composite selon la revendication précédente, dans lequel le luminophore est Y₃Al₅O₁₂ :Ce3+.

5. Composite selon l'une quelconque des revendications précédentes, dans lequel les particules fluorescentes ont un diamètre moyen supérieur à 500 nm, de préférence supérieur à 1 µm.

6. Composite selon l'une quelconque des revendications précédentes, dans lequel la matrice de polyuréthane transparente présente un facteur de transmission à un rayonnement situé dans les plages allant de 430 nm à 490 nm et de 500 nm à 700 nm de plus de 90%, de préférence de plus de 95%, et de manière davantage préférée de plus de 97%.

7. Dispositif émettant une lumière blanche, comprenant :
(a) une diode (DEL) émettant une lumière bleue, et
(b) une couche fluorescente,
**caractérisé en ce que** la couche fluorescente comprend un composite selon l'une quelconque des revendications précédentes.

8. Dispositif émettant une lumière blanche selon la revendication précédente, dans lequel la DEL bleue est positionnée au fond d'une cuvette concave comprenant une surface réfléchissante interne ainsi qu'une ouverture, et la couche fluorescente est positionnée entre la DEL bleue et l'ouverture de la cuvette, en masquant totalement l'ouverture de la cuvette pour la DEL bleue.

9. Dispositif émettant une lumière blanche selon la revendication 7 ou 8, dans lequel la couche fluorescente est séparée de la diode émettant une lumière bleue.

10. Substrat comprenant un motif imprimé appliqué sur au moins une de ses surfaces, **caractérisé en ce que** le motif imprimé est composé d'un composite selon l'une quelconque des revendications 1 à 6.

11. Substrat selon la revendication précédente, dans lequel le motif est appliqué avec une imprimante à jet d'encre, par sérigraphie ou par pulvérisation et la matrice de polyuréthane est durcie en étant exposée à un rayonnement, de préférence un rayonnement ultraviolet.

12. Procédé de production d'un composite fluorescent selon l'une quelconque des revendications 1 à 6, ledit procédé comprenant les étapes suivantes :
(a) l'obtention d'un mélange réactif de polyuréthane ;
(b) le mélange homogène avec ce dernier de particules fluorescentes pour obtenir une dispersion homogène ;
(c) l'application de la dispersion homogène sur un substrat ;
(d) le fait de permettre audit mélange réactif de polymériser, de préférence en chauffant à une température comprise entre 25°C et 100°C ou par exposition à un rayonnement, de préférence un rayonnement ultraviolet.

13. Procédé selon la revendication précédente, dans lequel le mélange réactif de polyuréthane comprend au moins un prépolymère à terminaison hydroxyle et/ou un prépolymère à terminaison isocyanate.

14. Procédé selon la revendication précédente, dans lequel le prépolymère présente une viscosité Brookfield comprise entre 100 mPa.s et 30 000 mPa.s, de préférence entre 300 mPa.s et 10 000 mPa.s, et de manière davantage préférée entre 500 mPa.s et 5000 mPa.s, mesurée à 25°C avec une tige de 27 à une vitesse de rotation de 10 tours/minutes.
